# EUROPEAN PATENT APPLICATION

(11) **EP 2 146 386 A1**
(43) Date of publication of application: **20.01.2010**
(21) Application number: 08167746.0
(22) Date of filing: 28.10.2008
(51) Int. Cl.: H01L 51/42

(54) **Photovoltaic structures and method to produce the same**

(30) Priority: 13.06.2008 US 61451 P
(71) Applicant: IMEC, 3001 Leuven (BE)
(72) Inventor: Rand, Barry, 3000, Leuven (BE); Genoe, Jan, 3272, Messelbroek (BE); Heremans, Paul, 3000, Leuven (BE)
(74) Representative: Bird, William Edward

(57) **Abstract**

A photovoltaic structure comprising:
- an electron acceptor material, and
- an electron donor material, wherein the electron donor material comprises:
- a host material, and
- a guest material,

wherein the energy of the lowest excited singlet state of the guest is smaller than the energy of lowest excited singlet state of the host, wherein the fluorescence emission spectrum of the host overlaps with at least part of the absorption spectrum of the guest and wherein the energy of the lowest excited triplet state of the guest is larger than the energy of the lowest excited triplet state of the host.

## Description

### Technical field of the invention

The present invention relates to the field of organic optoelectronics. More in particular, the present invention relates to photovoltaic structures and to methods to produce the same.

### Background of the invention

Recently, the power conversion efficiency of organic photovoltaics has improved rapidly, offering new potential as low-cost renewable energy sources, driven primarily by the development of new materials, device architectures, and processing techniques. Since the absorption of a photon in an organic semiconductor results in the creation of a bound electron-hole pair, also called an exciton, the device performance relies on the ability of excitons to diffuse to a donor-acceptor interface in order to dissociate into free charge carriers.
The major bottleneck for achieving highly efficient organic solar cells is balancing the low diffusion length (L_{D}), inherent to current organic semiconductors, while achieving sufficiently thick layers to absorb most of the incident light. In fact, the bulk heterojunction (BHJ) device concept, whereby the donor and acceptor materials are deposited simultaneously to form an interpenetrating donor-acceptor interface, was created in order to sidestep this trade-off.

However, it is difficult to achieve a very fine phase separation between the electron donor material and the electron acceptor material, of the order of a few L_{D}, while at the same time preserving the good charge transport required for low electrical resistance, efficient cells. This is possibly one reason for the large research effort focused on new processing techniques to obtain a high level of morphological control over the blend.

DE 102005010978 A1 discloses a device having an electron harvesting layer comprising a mixture of DCV3T and C₆₀. After excitation of a singlet exciton in DCV3T, the excitation energy is transferred to C₆₀. C₆₀ excitons then undergo inter-system crossing (ISC) with a certain probability, thereby generating an excited triplet state. Then, a back-transfer of energy from the excited triplet state in C₆₀ to that of DCV3T occurs. In this way, triplet excitons are generated in DCV3T.

### Summary of the invention

It is an object of the present invention to provide good photovoltaic configurations or structures having an organic semiconducting electron donor material capable of efficient exciton transport to a donor-acceptor interface. The above objective is accomplished by a method and a device according to the present invention.

An embodiment of the present invention has the advantages that relatively large L_{D}'s can be achieved for the photo-generated excitons when compared to prior art organic photovoltaic devices. Prior art organic photovoltaic devices are usually based on the light induced generation of singlet excitons. The exciton diffusion length, L_{D}, is typically of the order of 3 - 10 nm for singlet excitons. An embodiment of the present invention permits longer-lived triplet excitons to be generated (in the electron donor material), which have longer L_{D}'s than singlet excitons. Their generation allows for the harvesting of excitons generated further away from a donor-acceptor interface than was previously possible. With L_{D} increased, the ultimate device efficiency is also increased, both for planar heterojunction solar cells and for bulk heterojunction solar cells. In planar heterojunction organic solar cells, L_{D} values can be increased to values closer to the absorption length (i.e. absorption depth) than was previously possible. This drives the efficiency of a simple bilayer device architecture comprising a photovoltaic structure forming a planar heterojunction according to embodiments of the present invention toward values approaching that of a BHJ cell of the prior art. This embodiment is advantageous as it considerably simplifies device design and fabrication. In photovoltaic structures wherein the semi-conducting electron acceptor material and the semi-conducting electron donor material are mixed to form a bulk heterojunction according to embodiments of the present invention, use is made of the longer L_{D} of triplet excitons, allowing to relax the scale of separation between the donor and acceptor materials: a nano-morphology between donor and acceptor materials in a bulk heterojunction organic solar cell has usually a granularity of the order of L_{D}, and thus an increase in L_{D} leads to the possibility to use a coarser nano-morphology. This has implications on properties such as the mobility of charge carriers in the blend film and the amount of bulk recombination of electron and hole charge carriers leads to an increased photocurrent generation. Embodiments of the present invention disclose a method to convert absorbed photons into triplets in an absorbing organic semiconductor electron donor material. Triplets are virtually non-existent in optically excited fluorescent materials, as both direct generation by light as well as intersystem crossing (ISC) from singlets are inefficient processes. Embodiments of the present invention relate to a process of sensitized phosphorescence or sensitized triplet formation, whereby a properly chosen phosphorescent compound (e.g. a phosphorescent dye) converts initially generated host singlet excitons into triplet excitons. Embodiments of the present invention are advantageous as they may demonstrate enhanced photocurrent in a fluorescent material.

In a first aspect, the present invention relates to a photovoltaic structure comprising:
- an electron acceptor material, and
- an electron donor material, wherein said electron donor material comprises:
   - a host material, and
   - a guest material,
wherein the lowest excited singlet state of the guest is lower (i.e. has a lower energy) than the lowest excited singlet state of the host, wherein the fluorescence emission spectrum of the host (at least partially) overlaps with the absorption spectrum of the guest and wherein the lowest excited triplet state of the guest is higher (i.e. has a higher energy) than the lowest excited triplet state of the host.

In other words, the first aspect of the present invention relates to a photovoltaic structure comprising :
- a semiconductor electron acceptor material, and
- an organic semiconductor electron donor material, wherein said electron donor material comprises:
   - a host material, and
   - a guest material,
wherein the energy of the lowest excited singlet state of the guest is smaller than the energy of the lowest excited singlet state of the host, wherein the fluorescence emission energy spectrum of the host overlaps with the absorption spectrum of the guest (over at least part of the energy spectrum) and wherein the energy of the lowest excited triplet state of the guest is larger than the energy of the lowest excited triplet state of the host. Preferably, the electron acceptor material is organic.

As an optional feature, the highest occupied molecular orbital of the guest may be greater in energy (i.e. farther away from the vacuum energy level) than that of the host. This prevents charge trapping on the guest molecule and allows for efficient charge transport on the host molecule, enabling the host:guest system to have transport properties similar to that of the pure host for a charge carrier.

As another optional feature, the electron acceptor material and the host in the electron donor material may be selected so that an electron transfer occurs between said electron acceptor material and said host upon illumination of the electron donor material at a wavelength of absorption of the host (for instance, the electron acceptor material and the host may be selected so that an electron transfer occurs between said electron acceptor material and said host upon illumination of the electron donor material (at least) at the wavelength of maximal absorption of the host).

As another optional feature, the host may comprise an organic semi-conductor having at least a phenylene unit in its chemical structure (for instance, the host may comprise an organic semi-conductor having a fluorenylene unit in its chemical structure). As another optional feature, the host may comprise an organic semi-conductor having at least a thiophenylene unit in its chemical structure. As another optional feature, the host may comprise an organic semi-conductor having at least a selenophenylene unit in its chemical structure.

As another optional feature, the host may comprise an organic semi-conductor having an acene, an acenyl or acenylene unit in its chemical structure.

As another optional feature, the host may comprise an organic semi-conductor having a porphyrin unit in its chemical structure. As another optional feature, the host may comprise an organic semi-conductor having a phthalocyanin unit in its chemical structure. In some embodiments, carbene units can be present in the chemical structure eof the organic semi-conductor.

As another optional feature, the host may be selected form the group consisting of poly(para-phenylene vinylene) derivatives, poly(para-phenylene) derivatives, biphenyl derivatives, polythiophene derivatives, polyselenophene derivatives and aromatic tertiary amine derivatives.

As an embodiment of this optional feature, the semi-conducting electron donor material may comprise a poly(para-phenylene vinylene) derivatives having one of the following general formula: 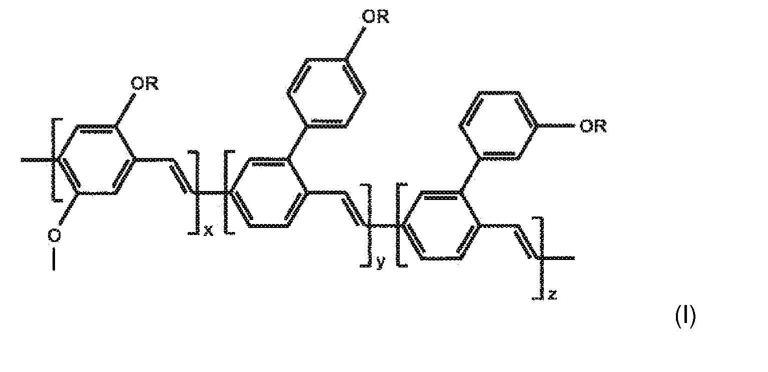 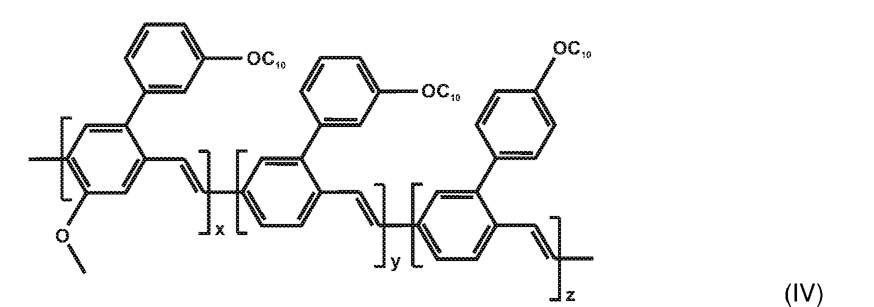 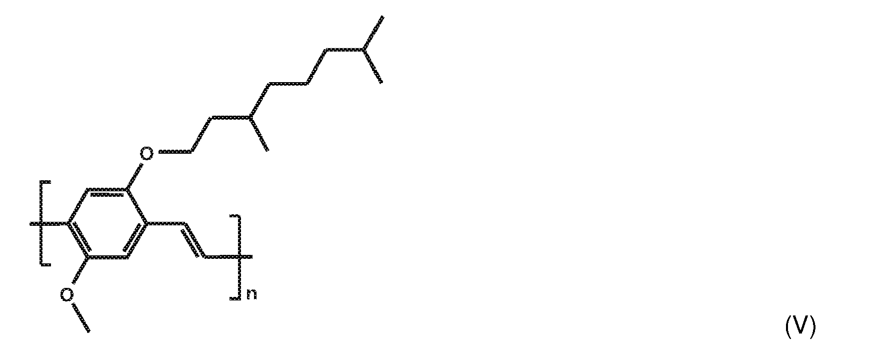 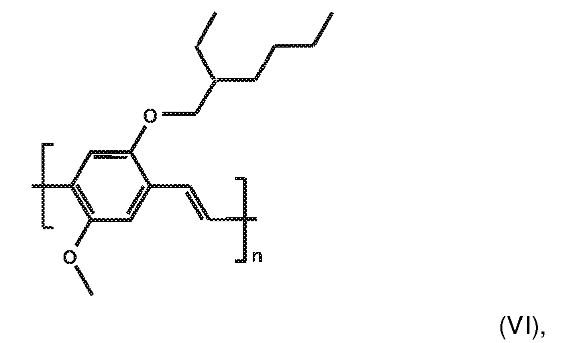 wherein R is an alkyl chain such as e.g. a C₁-C₁₂ alkyl chain, wherein x, y and z are such that the molecular weight (Mw) is from 10000 to 80000. In a specific embodiment R is 3,7-dimethyl-octyl and x/(y+z) is ∼1. In an embodiment, x/(y+z) is from 0.8 to 1.2. Preferably, y>z.
n is such that the molecular weight Mw is from 10000 to 80000.
C₁₀ is preferably 3,7-dimethyl-octyl.

As another optional feature, the guest may be selected from the group consisting of lanthanide metal chelates, heavy metal porphyrins, heavy metal phthalocyanines and iridium metal chelates. These guests, or dopants, have efficient intersystem crossing from singlet to triplet excitons due to spin-orbit coupling originating from the presence of a heavy metal atom. Examples of useable heavy metal atoms include but are not limited to Os, Ir and Pt amongst others.

As another optional feature, the guest may be selected from the group consisting of Tris[2-(2-pyridinyl)phenyl-C,N]-iridium (Ir(Ppy)₃), Iridium (III) bis[4,6-di-fluorophenyl-pyridinato-*N*,*C*2] picolinate [CAS Registry Number 376367-93-0] (Firpic) and platinum octaethylporphyrin (PtOEP).

As another optional feature, the host may be an aromatic tertiary amine compound and the guest may be Ir(ppy)₃. In an embodiment of this optional feature, said aromatic tertiary amine compound may be selected from the group consisting of N,N'- diphenyl benzidine (α-NPD) and N,N'-bis(3-methylphenyl)-N,N'-bis(phenyl)- benzidine (TPD).

As another optional feature, the host may be a polyparaphenylene derivative and the guest may be Ir(Ppy)₃.

In an embodiment of this optional feature, said polyparaphenylene derivative may be selected from the group consisting of polyfluorene derivatives, indenofluorene derivatives and ladder polyparaphenylene derivatives.

As another optional feature, the guest material may be platinum octaethylporphyrin (PtOEP).

As another optional feature, the guest material may be a diketone derivative such as but not limited to benzil (i.e. 1,2-diphenylethanedione) or 4,4'-Bis(dimethylamino)benzyl.

As another optional feature, the host material may be 4,4'-N,N'-dicarbazole-biphenyl (CBP) and the guest material may be bis[4,6-difluorophenyl-pyridinato-*N*, *C*2] picolinate (Firpic).

As another optional feature, the weight ratio guest/host may be from 0.001 to 0.20 or from 0.01 to 0.10 or from 0.02 to 0.09 or from 0.03 to 0.07. This range of weight ratios between guest and host allows for efficient quenching of host singlet excitons to the guest, without providing an excess of guest molecules which could disrupt charge and exciton transport on the host material.

As another optional feature, the semi-conductor electron acceptor material (e.g. s a layer) and the semi-conductor electron donor material (e.g. as a layer) may be adjacent and do not form a bulk heterojunction. In other words, the electron acceptor material and the electron donor material may form essentially a planar heterojunction.

As another optional feature, the electron acceptor material and the electron donor material may be mixed to form a bulk heterojunction.

As another optional feature, the photovoltaic structure according to any embodiments of the first aspect may further comprise conductive material layers (e.g. as electrodes). For instance at least two conductive layers may be used.

Preferably, one conductive layer is provided at the side of the photovoltaic structure closer or adjacent to the electron acceptor material and another conductive layer is provided at the side of the photovoltaic structure closer or adjacent to the electron donor material. In an embodiment, one or both of the conductive layers can take the form of a conductive substrate as defined elsewhere in this text.

In a second aspect, the present invention relates to a method for manufacturing a photovoltaic device. In an embodiment, the method may comprise the steps of:
- providing a substrate (e.g. a conductive substrate such as a substrate having a conductive layer),
- applying on said substrate (e.g on said conductive layer) a photovoltaic structure according to any embodiment of the first aspect of the present invention.

In an embodiment, the method may comprise the steps of:
- providing a substrate (e.g. a conductive substrate such as a substrate having a conductive layer),
- applying an electron donor material comprising a host material and a guest material on said substrate,
- applying an electron acceptor material on said electron donor material,
wherein the lowest excited singlet state of the guest is lower (i.e. has a smaller energy) than the lowest excited state of the host, wherein the fluorescence emission energy spectrum of the host overlaps (at least in part) with the absorption energy spectrum of the guest and wherein the lowest excited triplet state of the guest is higher (i.e. has a larger energy) than the lowest excited triplet state of the host.

In an other embodiment, the method may comprise the steps of:
- providing a substrate (e.g. a conductive substrate such as a substrate having a conductive layer),
- applying an electron acceptor material on said substrate,
- applying an electron donor material comprising a host material and a guest material on said electron acceptor material,
wherein the lowest excited singlet state of the guest is lower (i.e. has a smaller energy) than the energy of the lowest excited singlet state of the host, wherein the fluorescence emission energy spectrum of the host overlaps (at least in part) with the absorption energy spectrum of the guest and wherein the lowest excited triplet state of the guest is higher (i.e. has a larger energy) than the energy of the lowest excited triplet state of the host.

As an optional feature, a conductive layer may be applied on top of the photovoltaic structure, i.e. on the side opposite to the substrate.

As an optional feature to any embodiments of the second aspect of the present invention, the method may further comprise the step to provide electrical contacts (e.g. two contacts, on each conductive layer) to the photovoltaic structure. The contacts fulfill the purpose of extracting current generated in the photovoltaic structure. Contacts are preferably provided on the conductive layer(s).

In an embodiment of the second aspect, the present invention relates to a method for manufacturing a photovoltaic structure comprising the steps of:
- providing a semiconductor electron acceptor material, and
- providing a semiconductor electron donor material, wherein said electron donor material comprises:
   - a host material, and
   - a guest material,
   wherein the energy of the lowest excited singlet state of the guest is smaller than the energy of the lowest excited singlet state of the host, wherein the fluorescence emission energy spectrum of the host overlaps with the absorption spectrum of the guest and wherein the energy of the lowest excited triplet state of the guest is larger than the energy of the lowest excited triplet state of the host, and
- providing at least two substantially conducting layers. Preferably, one layer on one side of the photovoltaic structure, and one layer on the the other side of the photovoltaic structure.

Preferably, in any embodiment of the present invention involving two conducting layers (one on each side of the photovoltaic structure), at least on conducting layer may be at least partly transparent to at least a wavelength absorbed by the host of the electron donating material.

An embodiment of the second aspect of the present invention, relates to a method comprising the steps of:
- providing a substrate having a first conductive layer,
- optionally applying contacts on said first conductive layer,
- optionally applying a first set of one or more intermediate layers on said first conductive layer,
- applying a photovoltaic structure according to any embodiments of the first aspect on said first conductive layer or on top of said first set of one or more intermediate layers,
- optionally applying a second set of one or more intermediate layers on said photovoltaic structure, and
- optionally applying a second conductive layer on said photovoltaic structure or on top of said second set of intermediate layers.
wherein said first and second conductive layers are chosen so that at least one is at least partially transparent.

In any embodiments of the present invention, the conductive layers may be structured.

In a third aspect, the present invention relates to a method for operating a photovoltaic structure comprising the steps of:
- providing a photovoltaic structure according to any embodiment of the first aspect of the present invention,
- providing at least two substantially conducting contacts,
- extracting current from the photovoltaic structure upon illumination of said structure, and
- providing said current to a load.

In embodiments of the third aspect, the conducting contacts comprise conductive layers. For instance, a conductive layer is applied on a first side of the device (e.g. the electron acceptor side of the device in the case of a planar heterojunction) and/or a conductive layer is applied on the the other side of the device (e.g. the electron donor side of the device in the case of a planar heterojunction). In an embodiment, one or both of the conductive layers can take the form of a conductive substrate as defined elsewhere in this description.

In an embodiment, the load can be an electrical device to which electrical power is delivered such as a storage device (e.g. a battery or a capacitor), or an electrical device using the current produced to perform work or provide energy (e.g. a motor or a heater).

In an embodiment of the third aspect, the present invention relates to a method for operating a photovoltaic structure comprising the steps of:
- providing a semiconductor electron acceptor material, and
- providing a semiconductor electron donor material, wherein said electron donor material comprises:
   - a host material, and
   - a guest material,
   wherein the energy of the lowest excited singlet state of the guest is smaller than the energy of the lowest excited singlet state of the host, wherein the fluorescence emission energy spectrum of the host overlaps with the absorption spectrum of the guest and wherein the energy of the lowest excited triplet state of the guest is larger than the energy of the lowest excited triplet state of the host
- providing at least two substantially conducting contacts
- extracting current from the photovoltaic structure upon illumination of said structure, and
- providing said current to a load.

An other embodiment relates to a method of operation of a photovoltaic cell comprising the steps of:
- providing a photovoltaic structure according to any embodiment of the first aspect wherein a first conductive layer is applied on a first side of said structure and a second conductive layer is applied on a second side of said structure,
- connecting a load to said first and second conductive layer, and
- applying light to said photovoltaic structure, wherein said light comprises a wavelength that is at least partially absorbed by said host comprised in said electron donor material.

A further aspect of the present invention relates to the use of photovoltaic structure, according to any embodiment of the first aspect, for the fabrication of a photovoltaic cell.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

Fig. 1 is a graph of the absorption A and the emission E in arbitrary units versus the wavelength λ in nm for host Super Yellow (SY) and host:guest SY : PtOEP systems used in an embodiment of the present invention.
Fig. 2 is a graph of the absorption A and the emission E versus the wavelength λ in nm for host SY and host:guest SY : OEP systems used in comparative examples.
Fig. 3 is a graph of the emission intensity of phenyl-substituted poly(p-phenylene vinylene) (PPV) donor polymer Super Yellow (SY) {full chemical name: poly (2-[3'-(3,7-dimethyl-octyloxy)]5-methoxy-*p*-phenylenvinylen)co(2-[3'-(3,7-dimethyloctyl-oxy)]-phenyl-p-phenylenevinylene)} versus guest concentration G for PtOEP and OEP according to embodiments of the present invention and in comparative examples.
Fig. 4 is a schematic illustration of the energy transfers occurring in a host:guest system according to an embodiment of the present invention [SY : PtOEP], compared with that in a comparative example [SY : OEP].
Fig. 5 is a graph of the absorbance AB and emission intensity E of poly[2-methoxy-5-(2'-ethyl-hexyloxy)-1,4-phenylene vinylene] (MEH-PPV) A, A'and MEH-PPV:PtOEP B, B' (PtOEP stands for platinum octaethylporphyrin) versus the wavelength, λ.
Fig. 6 is a graph of the absorbance and emission intensity of poly(2-methoxy-5-(3',7'-dimethyl-octyloxy))-p-phenylene vinylene (MDMO-PPV) and MDMO:PtOEP versus the wavelength, λ.
Fig. 7 is a graph of the absorbance AB and emission intensity E of Green-PPV (a PPV derivative having the general formula IV) and Green-PPV:PtOEP versus the wavelength, λ.
Fig. 8 is a graph of the current density J versus voltage V for a photovoltaic structure according to an embodiment of the present invention. The inset is a schematic illustration of the energy levels of the components of this photovoltaic structure.
Fig. 9 is a graph of the short circuit current versus guest concentration in embodiments of the present invention and in comparative examples.
Fig. 10 is a graph of the external quantum efficiency spectra versus the wavelength in structures according to embodiments of the present invention and in comparative examples.
Fig. 11 is a graph of the difference between the external quantum efficiency spectra of host:guest structures and the external quantum efficiency spectra of host only structures. Graphs are shown for embodiments of the present invention and for comparative examples.
Fig. 12 is a schematic illustration of the energy levels of the components of a photovoltaic structure according to an embodiment of the present invention. It corresponds to an enlarged view of the insert of Fig. 8.
Fig.13 is a graph of the measured real (n) (upper panel) and imaginary (k) (lower panel) indices of refraction of thin films of SY (dashed line and C₆₀ (solid line).

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

The following terms are provided solely to aid in the understanding of the invention.

As used herein and unless provided otherwise, the term "*hosf*" relates to a material representing more than 50% of the weight of a material mixture (typically a host:guest system).

As used herein and unless provided otherwise, the term "*guest*" relates to a material representing less than 50% of the weight of a material mixture (typically a host:guest system)

As used herein and unless provided otherwise, the terms "*small molecule*" refers to a non-polymeric organic or organometallic molecule.

As used herein and unless provided otherwise, the terms "*sensitized phosphorescence*" and "*sensitized triplet formation*" relate to a process wherein triplets excitons are created in a host material by operating a singlet energy transfer from the host to the guest, an intersystem crossing within the guest and a triplet energy transfer from the guest to the host.

As used herein and unless stated otherwise, the use of the phrasing "*material A: material B*" relates to a host-guest system wherein A is the host and B is the Guest.

As used herein and unless provided otherwise, the term "*bulk heterojunction*" relates to donor and acceptor materials which are deposited simultaneously and/or are mixed to form an interpenetrating donor-acceptor interface wherein the donor and the acceptor are mixed together in the bulk and contain a relatively high surface area of dispersed interfaces when compared to planar heterojunction.

As used herein and unless provided otherwise, the term "*planar heterojunction*" relates to donor and acceptor materials which are deposited one after the other to form a donor-acceptor interface wherein the donor and the acceptor are not substantially mixed although the interface need not itself be planar in a macroscopic sense, i.e. the interface can be structured in order, for instance, to increase the surface area.

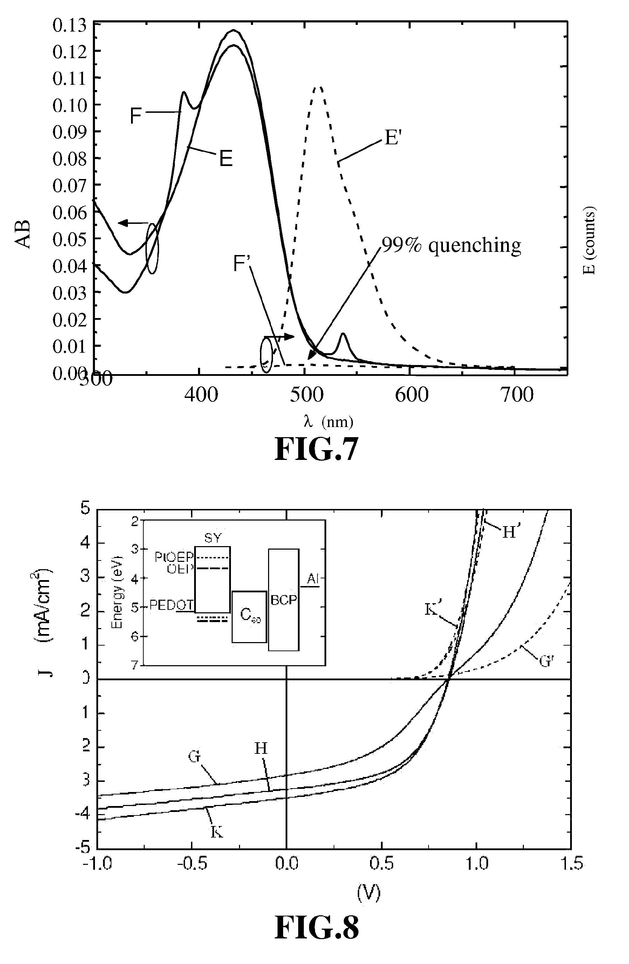

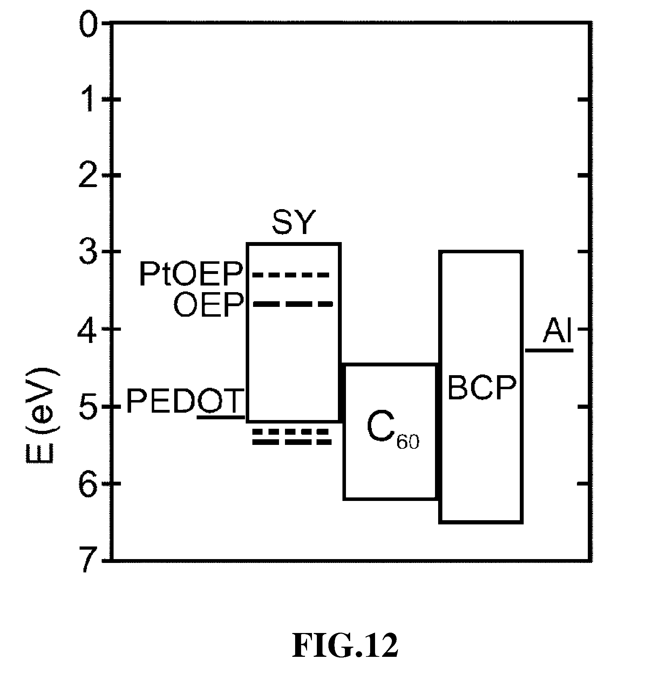

As used herein and unless provided otherwise, the terms "*vacuum level*" relates to the energy at which an electron becomes free from its ion. In Fig. 8 (insert) and Fig. 12 it is the level with 0 eV energy.

As used herein and unless provided otherwise, the term "*acene*" relates to a chemical group having the following formula wherein n is 0 to 5, preferably 1 to 3.

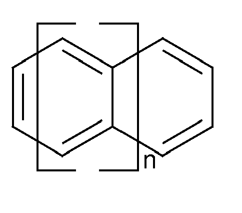

As used herein and unless provided otherwise, the term "*phenylene*" relates to benzene ring which is at least di-substituted, preferably in position 1 and 4.Fluorene, indenofluorene and ladder polyparaphenylene are examples of structures comprising one or more phenylene moieties.

As used herein and unless provided otherwise, the term "*derivative*" when applied to a chemical compound relates to a substituted or unsubstituted version of this compound.

For instance, the term "*PPV derivative*" relates to PPV itself or to substituted PPV, e.g. to 2, 5-substituted PPV, 2-substituted PPV or 5-substituted PPV. Typical examples of substituents on the phenylene rings for PPV derivatives are C₁-C₁₂ alkoxy chains. PPV derivatives also comprises PPV substituted on the vinylene (e.g. CN-PPV).

As another example, the term "*polyparaphenyle (PPP) derivative*" relates to PPP itself and to substituted PPP. Examples of substituted PPP are C₁-₁₂ alkyl substituted PPP, polyfluorene derivatives, polyindenofluorene derivatives, and ladder PPP derivatives. Polyfluorene, polyindenofluorene and ladder PPP can for instance be substituted on the methyl bridge (9,9' positions in fluorene) by C₁-C₁₂ alkyl chains, or an aryl or substituted aryl group such as phenyl, aniline, phenol, phenoxy, triarylamine, among others.

The invention will now be described by a detailed description of several embodiments of the invention. It is clear that other embodiments of the invention can be configured according to the knowledge of persons skilled in the art without departing from the true spirit or technical teaching of the invention, the invention being limited only by the terms of the appended claims.

In a first aspect, the present invention relates to a photovoltaic configuration comprising an electron acceptor material and an electron donor material.

The electron acceptor material may comprise any electron acceptor material known by the person skilled in the art to be usable in an organic photovoltaic structure. For instance, the electron acceptor material may comprise perylene derivatives (e.g. perylene tetracarboxidiimide, perylene tetracarboxidiimidazole such as 3,4,9,10-perylenetetracarboxylic bis-benzimidazole and the like), naphthalene derivatives (e.g. naphthalene tetracarboxidiimidazole, and the like), fullerene derivatives (e.g. buckminsterfullerene (C₆₀), C₇₀, C₈₄ and the like), nanotubule derivatives, anthraquinone acridone pigment, polycyclic quinone, CN- or CF₃-substituted poly(phenylene vinylene), fluorenone derivatives (polyfluorenone homo- and copolymers) amongst others. Mixtures of two or more of such electron acceptor materials can also be used. Preferably, the electron acceptor material comprises buckminsterfullerene (C₆₀)·

In an embodiment of the present invention, the electron acceptor material can comprise a mixture of two or more materials chosen in such a way that after excitation of a singlet exciton on the first material, the excitation energy can be transferred to the second material. In this embodiment, this would require that the lowest singlet excitation energy level of the second material is smaller than for the first material. In this embodiment, the second component is preferably chosen in such a way that singlet excitons transferred to it, can become triplet excitons with a probability of at least 50% via inter-system crossing. Such electron accepting (and electron harvesting) material can for instance be as described in DE 102005010978 A1 which is incorporated herein by reference in its entirety.

In embodiments, the electron acceptor material can be present as a layer, a dispersed phase (e.g. in electron donor material) or a matrix phase (a phase in which a dispersed phase is dispersed, e.g. in which an electron donor material is dispersed).

The electron donor material comprises a host material and a guest material. Optionally, more than one host material and/or more than one guest material may be used in combination in the same electron donor material. For the sake of clarity, the rest of this description will mainly describe embodiments wherein one host and one guest material are composing the electron donor material but it should be well understood that embodiments wherein more than one host material and/or more than one guest material are used in combination in the same electron donor material are also encompassed in the present invention.

In embodiments of the present invention, use is made of an electron donor material with host:guest system, preferably in the form of an electron donor layer, wherein the host (e.g. a fluorescent host material) accounts for most of the light absorption. In embodiments of the present invention, use is made of an electron donor material with a host:guest system, preferably in the form of an electron donor layer, wherein the host accounts for most of the charge transport. In embodiments of the present invention, use is made for the electron donating material of a host:guest system wherein the host operates most of the exciton transport. In embodiments of the present invention, the guest serves mainly (e.g. only) to generate triplets in the host. In the absence of a heterojunction with an acceptor material, the process of triplet generation in the host by use of a phosphorescent guest is named sensitized phosphorescence. In the presence of an acceptor material, the host may not emit phosphorescent light. Therefore, in more general terms the function of the guest may be called sensitized singlet to triplet conversion. Furthermore, the relatively low concentration of the guest molecules in the host matrix makes transport (e.g. of charges or excitons) and absorption by the guest molecules more difficult than in the host matrix. In embodiments of the present invention, the guest molecules participate to small or negligible degree in direct absorption or direct charge transport.

In embodiments of the present invention, the weight ratio guest/host is 0.001 or more, preferably 0.005 or more, more preferably 0.01 or more, still more preferably 0.02 or more, most preferably 0.03 or more. In embodiments of the present invention, the weight ratio guest host may be 0.20 or less, preferably 0.15 or less, more preferably 0.10 or less, still more preferably 0.09 or less, most preferably 0.07 or less. Any embodiments defining lower limits for the weight ratio guest/host can be combined with any embodiments defining higher limits for the weight ratio guest/host.

The host material in the donor material is preferably an organic hole transporting material.

The host can be a polymer (such as e.g. a semi-conductive polymer) or a small molecule.

Non-limiting examples of polymers suitable as host material in the donor material in embodiments of the present invention are hole transporting PPV derivatives (such as Super Yellow obtained from Merck OLED Materials GmbH

(see formula (I) wherein R is 3,7-dimethyl-octyl, wherein x/(y+z) is ∼1 and wherein y>z)), Green (see formula (IV)), MDMO (see formula (V)) or MEH (see formula (VI)) amongst others), polyparaphenylene derivatives (such as polyfluorene derivatives, polyindenofluorene derivatives, ladder polyparaphenylene derivatives (such as methyl-substituted ladder-type poly(para-phenylene) (MeLPPP, see formula VII), and the likes), polythiophene derivatives (e.g. a fluorene-thiophene alternating copolymer) and polyselenophene derivatives.

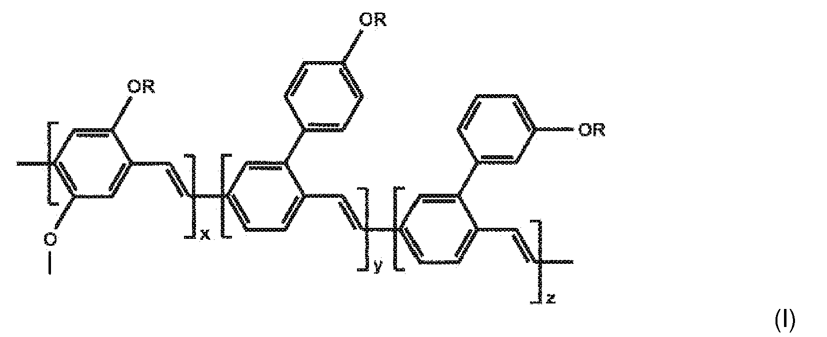

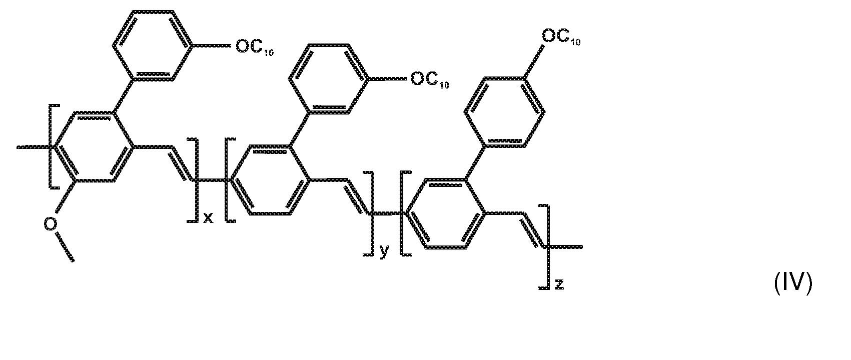

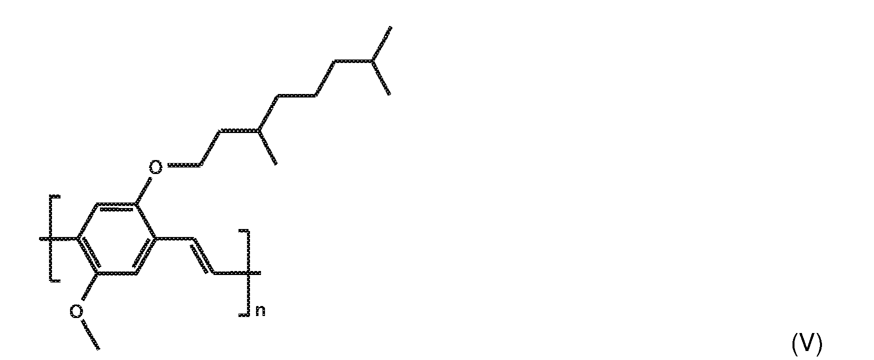

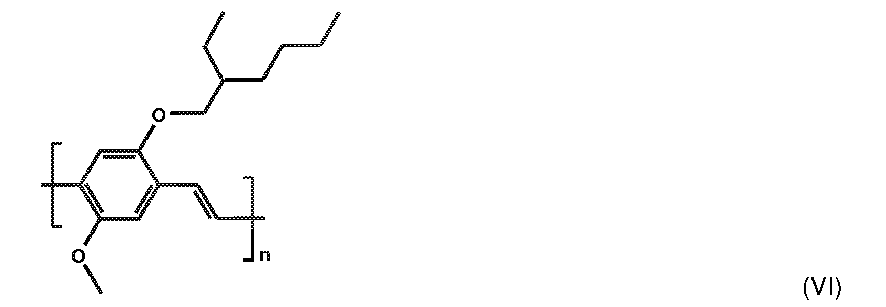

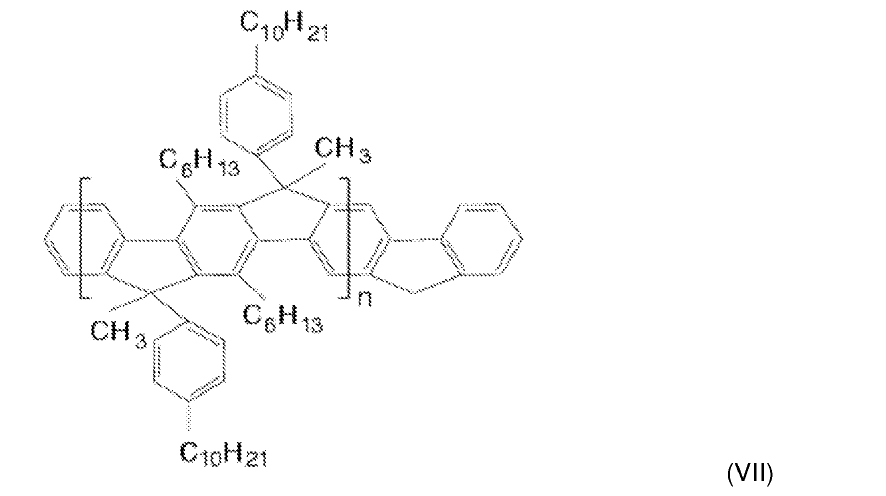

Non-limiting examples of small molecules suitable as host in the donor material in embodiments of the present invention are biphenyl derivatives such as 4,4'-bis[N-(1-naphthyl)-N-phenyl-amino]biphenyl; 4,4'-bis [N-(p-tolyl)-N-phenyl-amino]biphenyl, 4,4'-N,N'-dicarbazole-biphenyl (CBP), phthalocyanines, porphyrins and polyacenes (including tetracene and pentacene as well as polyacene derivatives such as e.g. anthradithiophene) amongst others.

The guest material in the donor material is preferably a phosphorescent dopant such as e.g. a lanthanide metal chelate, a metal phthalocyanines (e.g. copper phthalocyanine or platinum phthalocyanine), a metal porphyrin such as but not limited to platinium porphyrin (e.g. PtOEP) or zinc-tetra (4-carboxyphenyl)porphyrin, an iridium metal chelate (e.g. Tris[2-(2-pyridinyl)phenyl-C,N]-iridium (Ir(Ppy)₃) or Iridium (III) bis[4,6-di-fluorophenylpyridinato-*N*, *C*2] picolinate (Firpic)), amongst others. Other examples of possible dopant are diketone derivatives such as but not limited to Benzil (i.e.1,2-diphenylethanedione) or 4,4'-Bis(dimethylamino)benzil. Examples of diketone derivatives usable as dopant in embodiments of the present invention may have the following general formula: 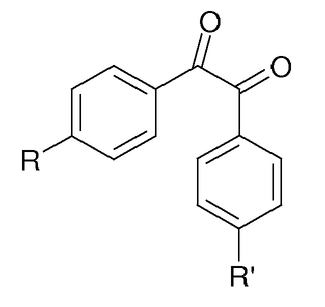 wherein R and R' are independently selected from the group consisting of H, CH₃, ethyl, propyl, -O-R" and NR"₂ wherein R" is selected from the group consisting of H, CH₃, ethyl and propyl. Preferably, R and R' are both H or N(CH₃)₂.

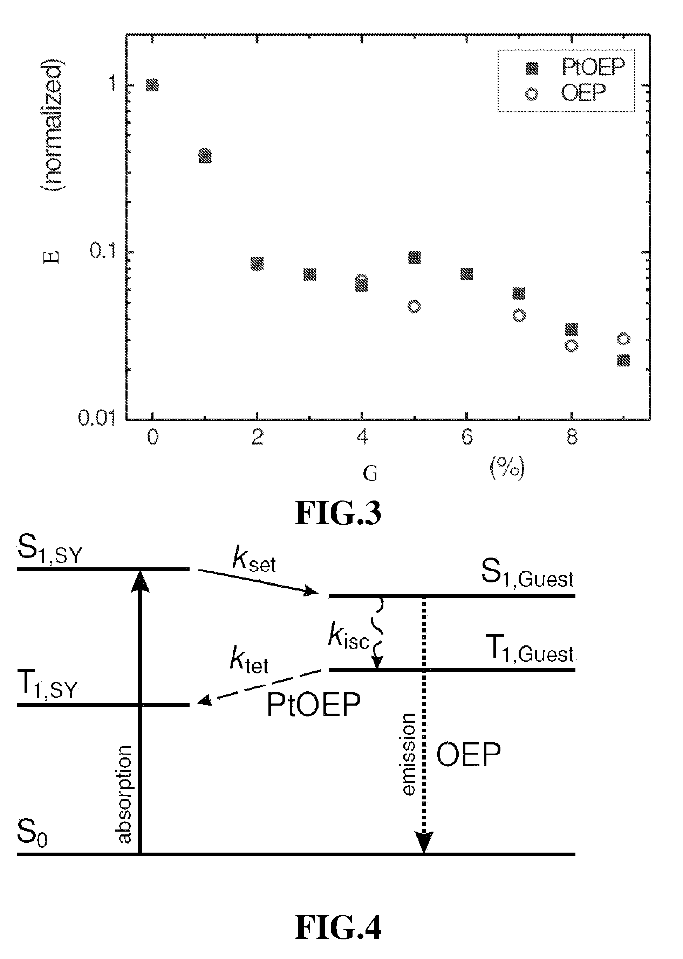

It is most preferred that the host material and the guest material in the donor material are chosen such that (i) the lowest excited singlet energy level of the guest is lower in energy (i.e. has a smaller energy) than the lowest excited singlet energy level of the host in the donor material (S_{1,guest} < S_{1,host}, see e.g. Fig. 4), the difference in energy being preferably at least a few kT (e.g. 3 kT or more, where k is Boltzmann's constant and T is the temperature) (ii) that the fluorescence emission spectrum of the host in the donor material overlaps with the absorption spectrum of the guest in the donor material ;preferably, there is sufficient overlap between the emission spectrum of the host in the donor material and absorption spectrum of the guest to allow for efficient singlet energy transfer (SET), for instance there may be at least 10% overlap between the normalised emission spectrum of the host and the normalised absorption spectrum of the guest, and (iii) that the lowest excited triplet state of the guest is higher in energy than the lowest excited triplet state of the host in the donor material (T_{1,guest} > T_{1,host}) (e.g. so that efficient triplet energy transfer (TET) can occur), the difference in energy being preferably at least a few kT (e.g. 3 kT or more). This is advantageous as it permits to generate efficiently triplets in the host in the donor material upon illumination of the host in the donor material.

It is also preferred, when selecting a guest-host couple for use in the electron donor material, that the highest occupied molecular orbital (HOMO) of the guest is greater in energy than that of the host. This condition is further explained in Fig. 12 wherein energy levels are represented for an embodiment of the present invention and wherein the vacuum level is at 0 eV on the energy (E) scale. On this figure, the highest occupied molecular orbital (HOMO) of the guest is greater in energy, i.e. further from the vacuum level, than that of the host. This is advantageous as it prevents holes from being trapped on the guest material which would ultimately reduce photocurrent.

It is also preferred, when selecting a couple of guest material and host material for use in the electron donor material, that the lowest unoccupied molecular orbital (LUMO) of the guest is higher in energy than the lowest unoccupied molecular orbital (LUMO) of the host. This is advantageous as it prevents trapping of electrons on guest sites as they move in the host matrix.

Examples of host:guest couples that are suitable for use in the donor material of the photovoltaic device according to embodiments of the present invention include aromatic tertiary amine compound:Ir(ppy)₃ such as for instance N,N'- diphenyl benzidine (α-NPD): Ir(ppy)₃ or N,N'-bis(3-methylphenyl)-N,N'-bis(phenyl)- benzidine (TPD): Ir(ppy)₃ amongst others.

Examples of host:guest couples that are suitable for use in the donor material of the photovoltaic device according to embodiments of the present invention include polyparaphenylene derivative: Ir(ppy)₃ such as but not limited to polyfluorene derivatives: Ir(ppy)₃ or MeLPPP: Ir(ppy)₃ amongst others.

Examples of host:guest couples that are suitable for use in the donor material of the photovoltaic device according to embodiments of the present invention include polyparaphenylene derivative:diketone derivatives such as but not limited to MeLPPP:benzil amongst others.

Examples of host:guest couples suitable for use in the donor material of the photovoltaic device according to embodiments of the present invention include but are not limited to PPV derivative:PtOEP such as but not limited to SY:PtOEP, Green PPV:PtOEP, MDMO PPV:PtOEP, MEH PPV:PtOEP amongst others.

Other example of host:guest couples suitable for use in the donor material of the photovoltaic device according to embodiments of the present invention include but are not limited to biphenyl derivative: Firpic such as but not limited to CBP: Firpic.

In embodiments of the present invention, it is preferred that the electron acceptor material and the host in the donor material are selected so that an electron transfer occurs between said electron acceptor material and said host upon illumination of the electron donor material at at least one wavelength (e.g. at the wavelength of maximal absorption) of the host absorption spectrum.

Preferably, the materials are carefully chosen so that efficient charge transport of photogenerated holes can occur through the host material in the donor material (e.g. by choosing a guest having its highest occupied molecular orbital (HOMO) farther from the vacuum level than that of the host.

In embodiments, the electron donor material can be present as a layer, a dispersed phase (e.g. in electron acceptor material matrix) or a matrix phase (a phase in which a dispersed phase is dispersed, e.g. in which an electron acceptor material is dispersed).

Host:guest systems can be prepared by any manner known to the person skilled in the art. For instance, the host and the guest can be co-deposited from a solution comprising both the host and the guest (by e.g. spin coating, dip coating or blade coating among others). If the host and the guest are sufficiently volatile, e.g. when they are both small molecules, they can be co-deposited from the gas phase (e.g via CVD).

A bulk heterojunction can be prepared by any method well known to the person skilled in the art. Typically, it can be fabricated by coating (e.g. spin coating) a solution comprising a mixture of the donor and acceptor materials. During (spin) coating and solvent evaporation, the donor and acceptor materials can phase separate, creating an intricate interpenetrating network with a large interfacial area between the two phases. The morphology of the resulting structure can be controlled by e.g. changing the spin conditions, solvents and relative material concentrations.

In a second aspect, the present invention relates to a method for manufacturing a photovoltaic device.

In an embodiment, the method may comprise the steps of:
- providing a substrate (e.g. a conductive substrate such as a substrate having a conductive layer), and
- applying on said substrate a photovoltaic structure according to any embodiment of the first aspect of the present invention.

In an embodiment, the method may comprise the steps of:
- providing a substrate (e.g. a conductive substrate such as a substrate having a conductive layer),
- applying an electron donor material comprising a host material and a guest material on said substrate,
- applying an electron acceptor material on said electron donor material,
wherein the lowest excited singlet state of the guest is lower (i.e. has a smaller energy) than the lowest excited state of the host, wherein the fluorescence emission energy spectrum of the host overlaps (at least in part) with the absorption energy spectrum of the guest and wherein the lowest excited triplet state of the guest is higher (i.e. has a larger energy) than the lowest excited triplet state of the host. This embodiment of the second aspect of the present invention relates to the fabrication of a component or structure usable to form a photovoltaic cell.

In an other embodiment, the method comprises the steps of:
- providing a substrate (e.g. a conductive substrate such as a substrate having a conductive layer),
- applying an electron acceptor material on said substrate,
- applying an electron donor material comprising a host material and a guest material on said electron acceptor material,
wherein the lowest excited singlet state of the guest is lower (i.e. has a smaller energy) than the energy of the lowest excited singlet state of the host, wherein the fluorescence emission energy spectrum of the host overlaps (at least in part) with the absorption energy spectrum of the guest and wherein the lowest excited triplet state of the guest is higher (i.e. has a larger energy) than the energy of the lowest excited triplet state of the host. In order to build a fully operational photovoltaic cell, two electrodes may be added to the photovoltaic structure, at least one of which has to be at least partly transparent for a part of the spectrum absorbed by at least one of the active semiconductor materials, the donor or the acceptor. Preferably, one of the electrode is on the electron donor side of the structure and the other electrode is on the electron acceptor side of the structure.

In another embodiment of the second aspect, the present invention relates to a method of manufacturing a photovoltaic device comprising the steps of:
- providing a suitable substrate, which may be flexible, rigid, planar, non-planar, transparent, opaque, or translucent, and of various thickness,
- applying a first electrode on said substrate,
- optionally applying contacts on said electrode,
- optionally applying a first set of one or more intermediate layers on said electrode,
- applying a photovoltaic structure according to any embodiments of the first aspect of the present invention on said first electrode or on top of said first set of one or more intermediate layers,
- optionally applying a second set of one or more intermediate layers on said photovoltaic structure, and
- optionally applying a second electrode on said photovoltaic structure or on top of said second set of intermediate layers.

In this embodiment, the first and second electrodes are preferably chosen so that at least one is at least partially transparent.

Embodiments of the first or second aspect of the present invention not comprising two conductive layers and/or contacts relate to components usable to form a photovoltaic cell comprising such conductive layers or contacts.

The conductive substrate can be formed of one material or of more than one material. For instance, the conductive substrate can comprise a conductive material optionally coated with one or more conductive layers or a nonconductive material coated with one or more conductive layers. The conductive substrate is preferably a transparent conductive substrate such as but not limited to ITO on glass. The conductive substrates and/or layers may be patterned. The substrate (e.g. a conductive substrate as defined above) can be flexible, rigid, planar, non-planar, transparent, opaque or translucent. It can be of any thicknesses.

In embodiments of the present invention, a conductive layer may be applied on one or both sides of the photovoltaic structure (e.g. one on the substrate and one on the top of the photovoltaic structure). Preferably, one conductive layer plays the role of a cathode and the other conductive layer plays the role of the anode. For instance, a cathode can be placed adjacent to the electron acceptor material and opposite to the electron donor material in the case of a planar heterojunction. The selection of an appropriate cathode is well within the skills of the person skilled in the art. Example of suitable cathodes are silver, aluminum, lithium, calcium and barium and their alloys amongst others.

The conductive layers may then be connected to an external load or circuit via a contact such as a wire, lead, or other means for transporting charges from the device to or from the load or circuit.

In embodiments of the present invention, one or more intermediate layers may be applied between the conductive substrate (e.g. a substrate having a conductive layer) and the electron donor material (or the mixture electron donor material/electron acceptor material in the case of a bulk heterojunction). The purpose of those layers can be to serve as hole injecting layer, hole transporting layer and/or electron blocking layer. Usable hole injecting layers (or hole transporting layer or electron blocking layer) are well known to the person skilled in the art and include for instance polyaniline ("PANI"), poly(3,4-ethylenedioxythiophene) ("PEDOT"), polypyrrole, organic charge transfer compounds (such as e.g. tetrathiafulvalene tetracyanoquinodimethane ("TTF-TCNQ")), as well as high work function metal oxides such as molybdenum oxide, vanadium oxide, and tungsten oxide, amongst others. The assembly of a conductive substrate (e.g. substrate having a conductive layer such as ITO on glass) and of said one or more intermediate (conductive or semi-conductive) layers is to be understood as forming a conductive substrate in the broadest sense.

In embodiments of the present invention, one or more intermediate layers may be applied adjacent to the electron acceptor material and opposite to the electron donor material (e.g. between the electron acceptor material and the conductive layer). The purpose of those layers can be to serve as electron-injecting layer and/or electron transport layer and/or hole-blocking layer. Usable electron injecting layers (or electron transport layer or hole-blocking layer) are well known to the person skilled in the art and include for instance a metal-chelated oxinoid compound (e.g., Alq₃ or aluminum(III)bis(2-methyl-8-quinolinato)4-phenylphenolate ("BAlq")); a phenanthroline-based compound (e.g., 2,9-dimethyl-4,7-diphenyl-1,10-phenanthroline ("DDPA") or 9,10-diphenylanthracence ("DPA")); an azole compound (e.g., 2-tert-butylphenyl-5-biphenyl-1,3,4-oxadiazole ("PBD") or 3-(4-biphenyl)-4-phenyl-5-(4-t-butylphenyl)-1,2,4-triazole ("TAZ"); an electron transport material as described in Kido; a diphenylanthracene derivative; a dinaphthylanthracene derivative; 4,4-bis(2,2-diphenyl-ethen-1-yl)-biphenyl ("DPVBI"); 9,10-di-beta-naphthylanthracene; 9,10-di-(naphenthyl)anthracene; 9,1 0-di-(2-naphthyl)anthracene ("ADN"); 4,4'-bis(carbazol-9-yl)biphenyl ("CBP"); 9,10-bis-[4-(2,2-diphenylvinyl)-phenyl]-anthracene ("BDPVPA"); anthracene, N-arylbenzimidazoles (such as "TPBI"); 1,4-bis[2-(9-ethyl-3-carbazoyl)vinylenyl]benzene; 4,4'-bis[2-(9-ethyl-3-carbazoyl)vinylenyl]-1,1'-biphenyl; 9,10-bis[2,2-(9,9-fluorenylene)vinylenyl]anthracene; 1,4-bis[2,2-(9,9-fluorenylene)vinylenyl]benzene; 4,4'-bis[2,2-(9,9-fluorenylene)vinylenyl]-1,1'-biphenyl; perylene, substituted perylenes; tetra-tert-butylperylene ("TBPe"); bis(3,5-difluoro-2-(2-pyridyl)phenyl-(2-carboxypyridyl)iridium III ("F(Ir)Pic"); a pyrene, a substituted pyrene; a styrylamine; a fluorinated phenylene; oxidazole; 1,8-naphthalimide; a polyquinoline; one or more carbon nanotubes within PPV, as well as low work function metal oxides such as titanium oxide and zinc oxide, amongst others.

There are different ways to assemble the electron acceptor material and the electron donor material.

In embodiments of the present invention, the electron acceptor material forms a layer adjacent to the electron donor material. In view of the longer L_{D} achieved by using electron donor material according to embodiments of the present invention, such a simple layered structure is usable. Embodiment of the present invention therefore relates to a photovoltaic structure comprising an electron acceptor layer, and an electron donor layer, wherein said electron donor layer is as described in any embodiments of the first aspect of the present invention and wherein the electron acceptor layer and the electron donor layer are adjacent and do not intermix significantly. In this embodiment, some degree of intermixing at the interface between both layers is permissible.

In another embodiment of the present invention, the electron acceptor layer and the electron donor layer can form a bulk heterojunction (BHJ).

### Example 1: Investigation of the usability in embodiments of the present invention of a SY:PtOEP host:guest system in a donor material.

We use as an example the phenyl-substituted poly(p-phenylene vinylene) (PPV) donor polymer Super Yellow (SY) obtainable from Merck OLED materials GmbH

(see formula (I)) doped with the phosphorescent molecule platinum octaethylporphyrin (PtOEP) (see formula II).

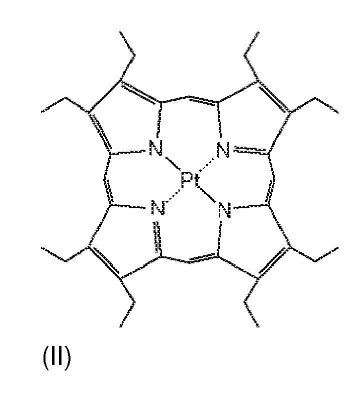

Furthermore, the effect of doping with the Pt-free analogue of (II) octaethylporphyrin (OEP) (III) was investigated to demonstrate the opposite effect: a dopant that allows singlet energy transfer (SET) but not triplet energy transfer (TET) is expected to actually reduce the photocurrent.

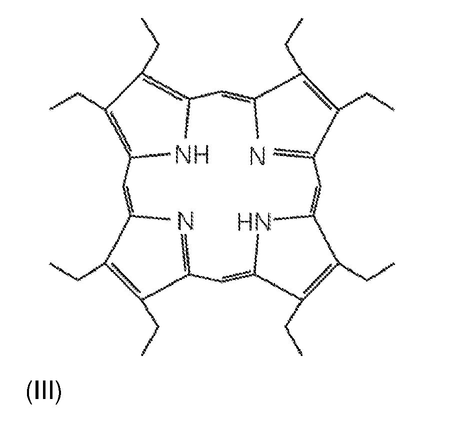

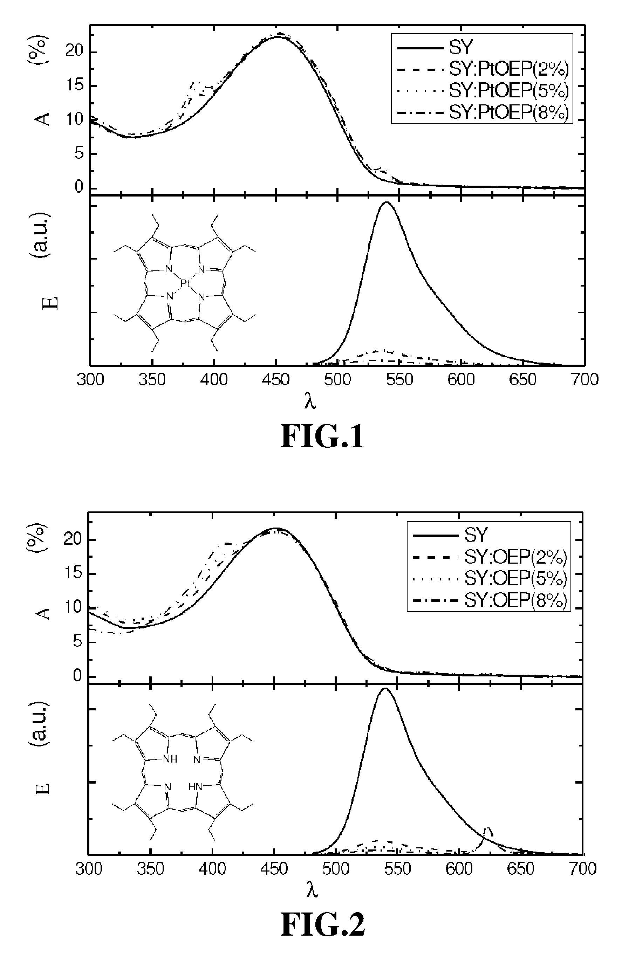

Fig. 1 shows the absorption and emission of a pure SY (I) film as well as films doped with PtOEP (II), whereas Fig. 2 shows SY (I) films doped with OEP. The absorption shoulders of PtOEP (II) and OEP (III) are present in the doped films, at wavelengths of λ = 385 and 535 nm for PtOEP (II) and at λ = 410 nm for OEP (III), and the intensity of these peaks increases with doping concentration. The SY (I) emission, with its peak at λ = 540 nm, is quenched rapidly as a result of the introduction of either dopant. Indeed, as shown in Fig. 3, the SY (I) emission is decreased to below 10% of its initial value upon the addition of 2% PtOEP (II) or OEP (III) in the polymer matrix, and decreases further still with increasing dopant concentration. Perhaps most importantly, however, is that PtOEP (II) phosphorescence at λ = 650 nm is not present, whereas OEP (III) fluorescence at λ = 625 nm is observed. This suggests the excitonic pathways illustrated schematically in Fig. 4, where for the case of PtOEP (II) there is efficient SET from SY (I) to PtOEP (II) molecules, followed by ISC, and finally TET back to SY (I) owing to the lower triplet energy of SY (I) (∼1.6 eV) compared to that of PtOEP (II) (∼1.9 eV). In the case of OEP (III), SET to the OEP (III) dopant occurs, but since OEP (III) is a fluorescent molecule, ISC efficiency is very low and singlet OEP (III) emission is observed.

### Example 2: Investigation of the usability in embodiments of the present invention of a MEH-PPV:PtOEP host:quest system in a donor material.

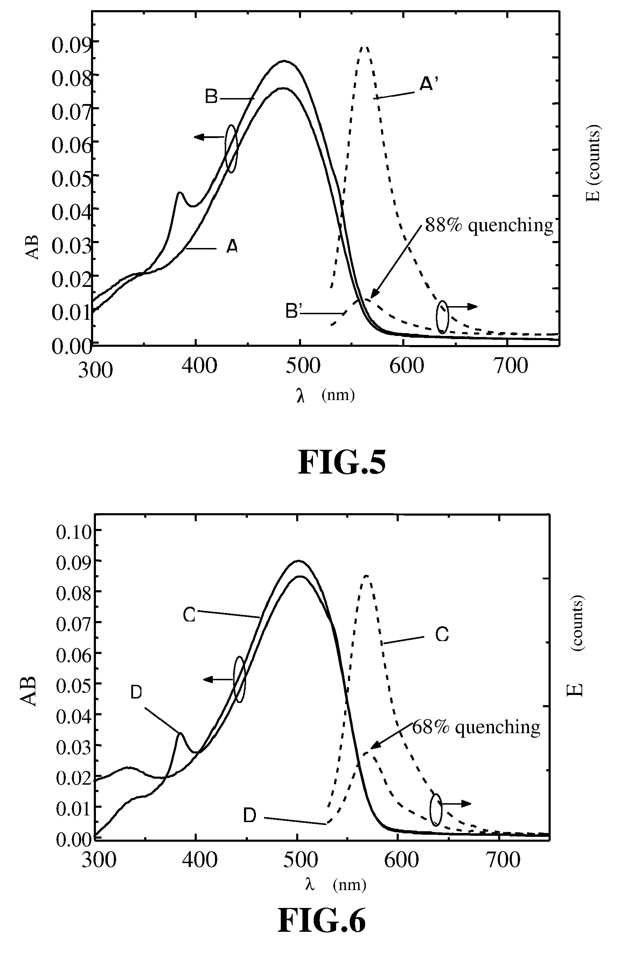

Fig. 5 shows the absorption and emission of a pure MEH-PPV (VI) film (curves A and A' respectively) as well as films doped with PtOEP (II) (curves B and B' respectively). The absorption shoulder of PtOEP (II) is present in the doped films, at the wavelength of λ = 385 nm. The MEH-PPV (VI) emission, with its peak at λ = 562 nm, is quenched as a result of the introduction of the guest PtOEP (II). Indeed, as shown in Fig. 5, the MEH-PPV (VI) emission is decreased to about 12% of its initial value upon the addition of 5% PtOEP (II) in the polymer matrix. Perhaps most importantly, however, is that PtOEP (II) phosphorescence at λ = 650 nm is not present. This suggests a similar excitonic pathways than illustrated schematically in Fig. 4, where for the case of PtOEP (II) there is efficient SET from MEH-PPV (VI) to PtOEP (II) molecules, followed by ISC, and finally TET back to MEH-PPV (VI) owing to the lower triplet energy of MEH-PPV (VI) (∼1.6 eV) compared to that of PtOEP (II) (∼1.9 eV).

### Example 3: Investigation of the usability in embodiments of the present invention of a MDMO-PPV:PtOEP host:guest system.

Fig. 6 shows the absorption and emission of a pure MDMO-PPV (V) film (curves C and C' respectively) as well as films doped with PtOEP (II) (curves D and D' respectively). The absorption shoulders of PtOEP (II) is present in the doped films, at the wavelength of λ = 385 nm. The MDMO-PPV (VI) emission, with its peak at λ = 567 nm, is quenched as a result of the introduction of the guest PtOEP (II). Indeed, as shown in Fig. 6, the MDMO-PPV (VI) emission is decreased to about 32% of its initial value upon the addition of 5% PtOEP (II) in the polymer matrix. Perhaps most importantly, however, is that PtOEP (II) phosphorescence at λ = 650 nm is not present. This suggests a similar excitonic pathways than illustrated schematically in Fig. 4, where for the case of PtOEP (II) there is efficient SET from MDMO-PPV (VI) to PtOEP (II) molecules, followed by ISC, and finally TET back to MDMO-PPV (VI) owing to the lower triplet energy of MDMO-PPV (VI) (∼1.6 eV) compared to that of PtOEP (II) (∼1.9 eV).

### Example 4: Investigation of the usability in embodiments of the present invention of a Green PPV:PtOEP host:guest system.

Fig. 7 shows the absorption and emission of a pure Green-PPV (IV) film (curves E and E' respectively) as well as films doped with PtOEP (II) (curves F and F' respectively). The absorption shoulders of PtOEP (II) is present in the doped films, at wavelengths of λ = 385 nm. The Green-PPV (VI) emission, with its peak at λ = 513 nm, is quenched as a result of the introduction of the guest PtOEP (II). Indeed, as shown in Fig. 7, the Green-PPV (VI) emission is decreased to about 1% of its initial value upon the addition of 5% PtOEP (II) in the polymer matrix. Perhaps most importantly, however, is that PtOEP (II) phosphorescence at λ = 650 nm is not present. This suggests a similar excitonic pathways than illustrated schematically in Fig. 4, where for the case of PtOEP (II) there is efficient SET from Green-PPV (VI) to PtOEP (II) molecules, followed by ISC, and finally TET back to Green-PPV (VI) owing to the lower triplet energy of Green-PPV (VI) (1.6 eV) compared to that of PtOEP (II) (∼1.9 eV).

### Example 5: device fabrication and performance.

In this example, it is demonstrated how an embodiment of the present invention (via a new process of sensitized phosphorescence or sensitized triplet formation in an electron donor material), can be used to increase the photocurrent in an absorbing layer.

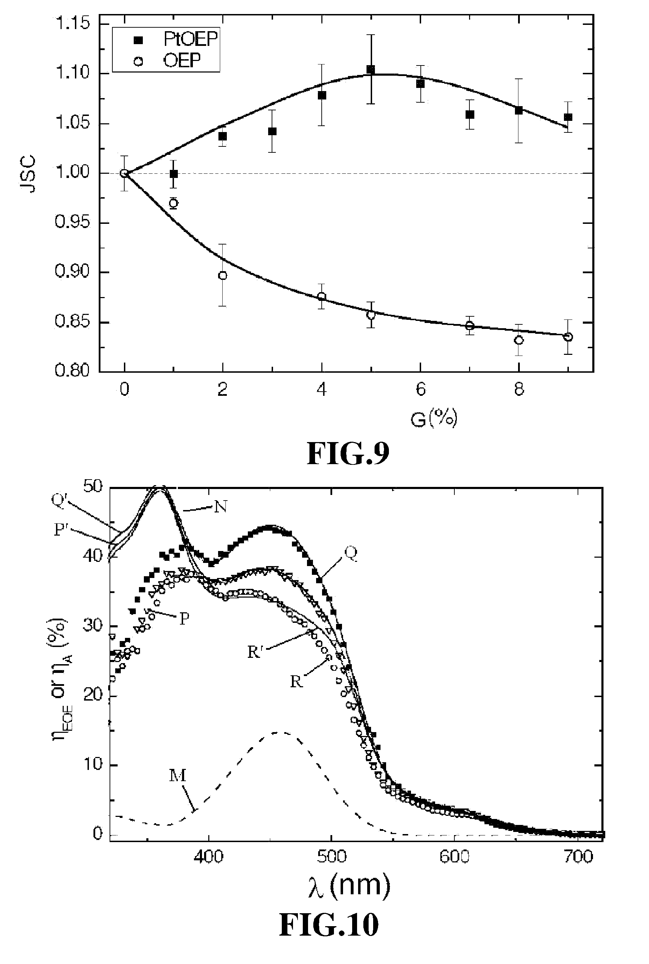

For the demonstration of sensitized phosphorescence in a solar cell, the following device structure was used: indium-tin-oxide (ITO)/poly(3,4-ethylenedioxythiophene):poly(styrene sulfonate) (PEDOT) (30 nm)/SY (15 nm)/C₆₀ (30 nm)/bathocuproine(BCP) (8 nm)/Al (80 nm). Here, ITO/PEDOT served as the anode, SY as the donor layer, C₆₀ as the acceptor layer, BCP as an exciton blocking layer, and Al as the cathode. The schematic energy diagram of this device is shown in the inset to Fig.8. Fig.8 also shows the current density vs. voltage (J-V) characteristics of devices with undoped SY (H,H'), SY:PtOEP(5%) (K, K'), and SY:OEP(5%) (G, G') donor layers in the dark (dashed lines G', H' and K') and under illumination of 100 mW/cm² AM1.5D simulated solar illumination (solid lines G, H and K). The undoped SY-based device has a short circuit current density JSC = 3.2 mA/cm², open circuit voltage VOC = 0.86 V, fill factor FF = 0.54, and power conversion efficiency ηₚ = 1.5%. The doped devices have the same value of VOC, which indicates that the host SY acts as the charge conducting material, a property which is expected for films containing a low concentration of dopant (<10%) and also owing to the shallower HOMO of SY with respect to that of either PtOEP or OEP (i.e. the HOMO of SY is lower in energy/closer to the vacuum level than PtOEP or OEP, see Fig.8 and Fig.12). The PtOEP-doped device has a dark current almost identical to that of the undoped device, and JSC = 3.5 mA/cm², FF = 0.52, and ηₚ = 1.6% under illumination. In this case, the photocurrent is increased by almost 10%, whereas the FF is slightly decreased, which could indicate that the presence of the PtOEP dopant molecule interrupts charge carrier transport in the SY matrix, making the collection of photogenerated charges more difficult. For the case of 5% OEP doping, JSC = 2.8 mA/cm², FF = 0.41, and η_{P} = 1%. Here, the OEP dopant increases the series resistance of the cell, as reflected in the lower dark current at V ≥ 0.7 V as compared to the other devices. This has the effect of reducing the FF, but does not significantly impact JSC, as an equally reduced photocurrent can be observed even for negative voltages, where photogenerated carriers are efficiently extracted by the applied field. To understand better the influence of the dopant and whether sensitized phosphorescence plays a role in the device operation, we show in Fig. 9 the dependence of JSC on dopant concentration for either PtOEP or OEP doping. It should be noted that the roughness and therefore the interfacial area of the donor-acceptor heterojunction does not increase with doping concentration, as measured by atomic force microscopy of doped and undoped SY films. Atomic force microscopy images were measured with a Picoscan PicoSPM LE scanning probe microscope operated in the tapping mode. These AFM images were representative, and showed that both the pure Super Yellow (SY) film and the film doped with 8% platinum octaethylporphyrin (PtOEP) have smooth surface morphologies, indicative of amorphous films. The root mean square roughnesses for both the SY and SY:PtOEP(8%) surfaces were 0.6 nm. This is interesting because it indicates that an increased (or decreased) photocurrent in the solar cell is not a result of an increase (or decrease) in the interface area between donor and acceptor layers.

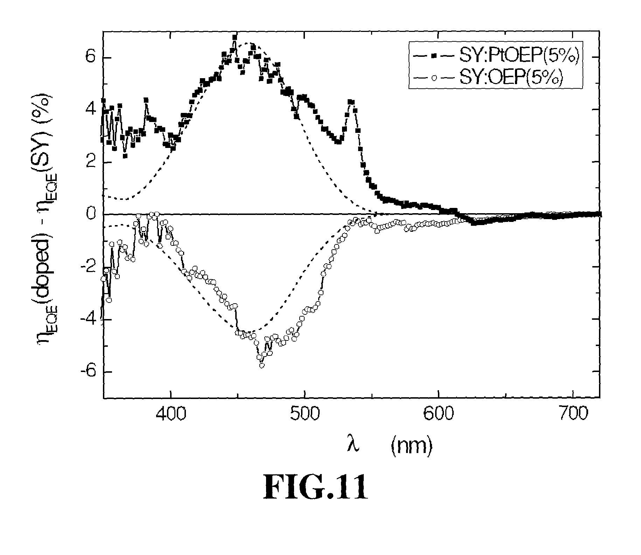

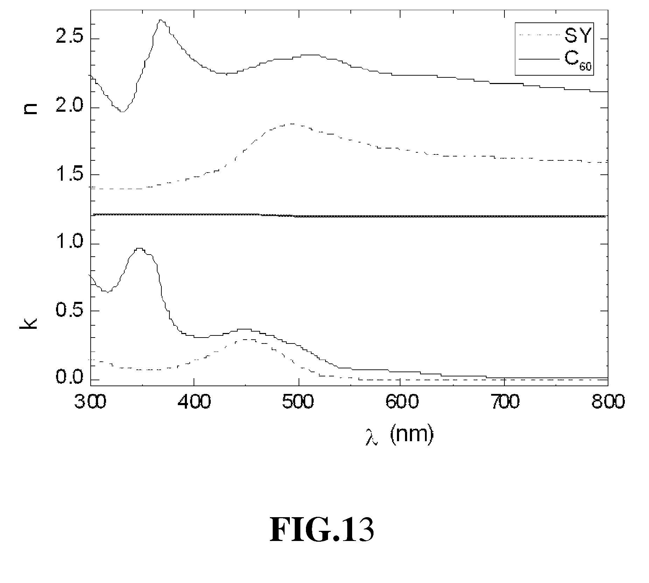

With an increase in PtOEP concentration, JSC increases by approximately 10%, peaking at a dopant concentration of 5%, beyond which the increase in JSC is reduced. In contrast, the addition of OEP to the SY matrix always results in a decrease of JSC, which appears to saturate at a reduction of approximately 15-18%. This can be understood by considering again the results of Fig. 1-4, where SY singlets are immediately quenched by the addition of small amounts of the dopant. Once a sufficient doping level has been reached in order to quench a large percentage of the SY excitons, increasing the dopant concentration only suppresses further the transport of charges and/or excitons in the SY layer, resulting in a decreased performance and therefore the presence of an optimal PtOEP concentration. Indeed, the fact that both dopants efficiently quench SY excitons but only PtOEP doping leads to an enhancement of JSC provides significant evidence that excitons are returned to SY in that case, whereas with OEP doping they are lost. Nevertheless, as further evidence of the sensitized phosphorescence mechanism, we consider the external quantum efficiency (η_{EQE}) spectra of doped (curves Q, R) and undoped (curve P) devices, as shown in Fig. 10. To highlight the relative contributions from SY and C₆₀, we also show the calculated absorption efficiency (η_{A}) spectra for SY (curve M) and C₆₀ (curve N). The SY contribution is centred at λ = 455 nm, whereas C₆₀ is responsible for the shoulder at λ = 435 nm and the tail extending to λ = 650 nm. The reduction of η_{EQE} at λ ≤ 375 nm is due to reflection and absorption from the glass/ITO substrate, resulting in a "false peak" in the measured η_{EQE} at λ = 375 nm. The η_{EQE} spectrum of the cell (curve P) with a pure SY donor layer shows distinct features of both SY and C₆₀. From η_{A}, it is clear that there is a larger contribution to the photocurrent originating from the C₆₀ acceptor layer compared to that of SY, which contributes approximately 15% of the total current, and which is consistent with the fact that OEP doping results in a reduction of JSC by approximately the same amount (c.f. Fig. 9). The calculated η_{EQE} spectrum for the undoped device (curve P') closely fits that of the measured data, and yields an estimate of L_{D} ∼ 4 nm, in excellent agreement to that of other PPV derivatives. For the device with a SY:OEP(5%) donor layer (curve R), the contribution from SY is barely visible, functioning instead almost completely on C₆₀. Indeed, spectral fitting for this device requires L_{D} ∼ 1 nm, indicating that only SY excitons formed at the interface with C₆₀ are able to contribute. This is consistent with the fact that OEP quenches most SY excitons and confines them to the OEP dopant, eliminating the opportunity to dissociate at the donor-acceptor interface. The η_{EQE} spectrum of the SY:PtOEP(5%) (Curve Q) shows instead an enhancement of the SY signal, peaking at λ = 450 nm to η_{EQE} = 45%. Here, SY contributes approximately 21 % of the total current, an increase of about 40% compared to the undoped SY donor layer. In this case, L_{D} of SY triplet excitons is longer than that of singlet excitons, and therefore a larger percentage of photons absorbed in the SY layer are able to contribute to photocurrent. We are again able to obtain an excellent spectral fit (curve Q'), and this provides an estimate of L_{D} ∼ 9 nm, significantly greater than that of the pure SY film. If we take the difference between η_{EQE} of doped versus undoped devices, we obtain the curves as shown in Fig. 11. Here the difference between the PtOEP-doped and pure SY devices is a result of increased signal from SY, as well as small contributions from PtOEP at λ = 385 and 535 nm. These contributions from PtOEP provide further evidence of the triplet transfer process, as direct absorption of PtOEP generates triplet excitons which transfer to SY and are transported to the donor-acceptor interface, contributing to photocurrent. By contrast, the difference between the OEP-doped device and pure SY is negative and corresponds to a loss in the SY spectral response. Also in this spectrum, no additional contribution from the OEP dopant is observed, as would be expected for these immobile singlet excitons. The dotted line (top) represents the differences in the fits (Q'-P') of Fig.10. The dotted line (bottom) represents the differences in the fits (R'-P') of Fig.10. Ellipsometry measurements were performed with a GES5 Variable Angle Spectroscopic Ellipsometer (VASE) from SOPRA. Figure 13 shows the measured real (n) and imaginary (k) parts of the indices of refraction for SY and C₆₀. These spectra are then used as inputs to a transfer-matrix based calculation which takes into account optical interference e_ects and exciton diffusion. For the calculations, the diffusion length of C₆₀ was taken to be constant for all 3 devices, at a value of LD = 18 nm. Then, the poly(3,4-ethylenedioxythiophene):poly(styrene sulfonate) (PEDOT)/SY and C₆₀/bathocuproine (BCP) interfaces were taken to have a quenching efficiency equal to 0, whereas the SY/C₆₀ (as well as the SY:PtOEP/C₆₀ and SY:OEP/C₆₀) interface was taken to have a quenching efficiency equal to unity. By also assuming a unity quenching efficiency for the triplet excitons, a lower limit for the diffusion length of excitons in the SY:PtOEP layer is being determined, as it is possible that the triplet excitons may have a lower charge transfer efficiency as a result of the higher binding energy of SY triplet excitons with respect to SY singlet excitons.

In conclusion, this example experimentally demonstrates an organic solar cell with a donor layer enhanced by the process of sensitized phosphorescence. By converting optically excited singlet excitons to triplet excitons efficiently, L_{D} was more than doubled, from 4 to 9 nm. In contrast, a similar dopant which lacks the ability to convert host singlet excitons to triplet excitons was shown to reduce the photocurrent from the host material. The ability to increase L_{D}, ideally toward distances equal to the absorption length in organic materials can allow simplified bilayer architectures to possess efficiencies approaching that of BHJ devices, or can at least relax the restrictions placed on the phase separation of blends.

The ITO coated glass substrates (Merck Display Technologies, ITO thickness 100 nm, sheet resistance <20Ω / ) were solvent cleaned followed by UV/O₃ treatment for 10 min. The PEDOT (H.C. Starck, Baytron P VPAI4083) solution was spincast at 3000 rpm for 60 s to yield a 30 nm thick film, followed by baking at 120°C to remove water. The SY was dissolved in toluene at a concentration of 1.7 mg/ml, with doping of PtOEP or OEP by weight, followed by spincasting at 2000 rpm for 60 s. The samples were transferred to an ultrahigh vacuum chamber (base pressure < 5 X 10⁻⁹ Torr) for deposition of C₆₀ and BCP (deposition rate ∼1.0 Å/s, followed by Al deposition (deposition rate ∼2-3 Å /s). The samples were then loaded into a concealed measurement unit in an N₂ atmosphere for testing. The device area was measured with an optical microscope, with an average area of 3.3 mm². Films for absorption and emission were deposited directly onto clean quartz substrates. The absorption spectra were measured using a Shimadzu UV-1601 PC spectrophotometer, while emission was measured with a Shimadzu RF-5301 PC spectrofluorophotometer, with an excitation λ_{exc} = 385 nm. The J-V characteristics were measured using an Agilent 4156C parameter analyzer with illumination from a LOT-Oriel 1000 W Xe arc lamp fitted with AM 1.5D

filters. Calibration was performed by a KG3 band pass filter and a calibrated Si photodetector. For the measurement of λ_{EQE}, light from a Xe arc lamp (Lot-Oriel 300W O₃-free) was coupled into a monochromator (Jobin-Yvon H25). The monochromatic light intensity was calibrated under normal incidence with a Si photodiode (Newport 818-UV). The light incident on the device was chopped by a square-wave at 300 Hz (Stanford Research 540) and the modulated current signal was detected with a current-voltage amplifier (Stanford Research 570) and lock-in amplifier (Stanford Research 810). During measurement, the device was kept in a vacuum of <10⁻⁴ Torr.

It is to be understood that although preferred embodiments, specific constructions and configurations, as well as materials, have been discussed herein for devices according to the present invention, various changes or modifications in form and detail may be made without departing from the scope and spirit of this invention. Steps may be added or deleted to methods described within the scope of the present invention.

## Claims

1. A photovoltaic structure comprising :
- a semiconductor electron acceptor material, and
- a semiconductor electron donor material, wherein said semiconductor electron donor material comprises:
- a host material, and
- a guest material,
wherein the energy of the lowest excited singlet state of the guest is smaller than the energy of the lowest excited singlet state of the host,
wherein the fluorescence emission energy spectrum of the host overlaps at least in part with the absorption spectrum of the guest and wherein the energy of the lowest excited triplet state of the guest is larger than the energy of the lowest excited triplet state of the host.

2. The photovoltaic structure according to claim 1, wherein the energy of the highest occupied molecular orbital of the guest is farther from the vacuum energy level than that of the host.

3. The photovoltaic structure according to claim 1 or claim 2, wherein the electron acceptor material and the host are selected so that an electron transfer occurs between said electron acceptor material and said host upon illumination of the electron donor material at at least one wavelength.

4. The photovoltaic structure according to claim 3, wherein said host comprises an organic semiconductor having at least one moiety in its chemical structure selected from the group consisting of phenylene, thiophenylene, selenophenylene, vinylene, acene, porphyrin, phthalocyanine, flurorene or indenofluorene.

5. The photovoltaic structure according to any of claims 1 to 4, wherein the host is selected from the group consisting of poly(para-phenylene vinylene) derivatives, poly(para-phenylene) derivatives, biphenyl derivatives, polythiophene derivatives, polyselenophene derivatives, and aromatic tertiary amine derivatives.

6. The photovoltaic structure according to any of claims 1 to 5, wherein the host material comprises a poly(para-phenylene vinylene) derivative having one of the following general formula: 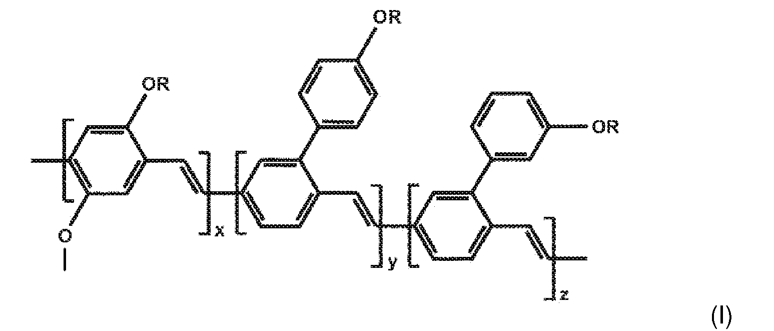 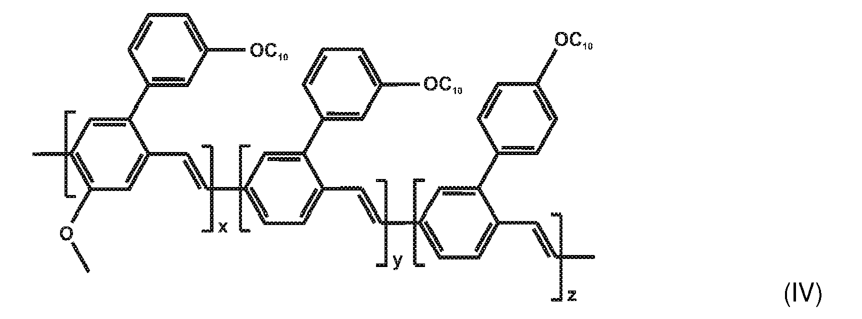 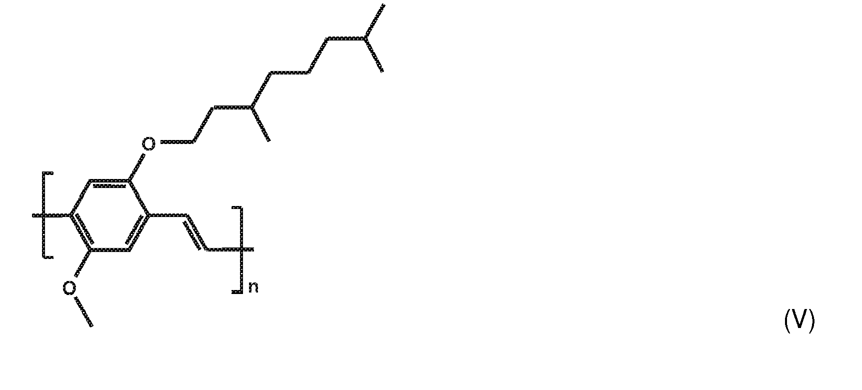 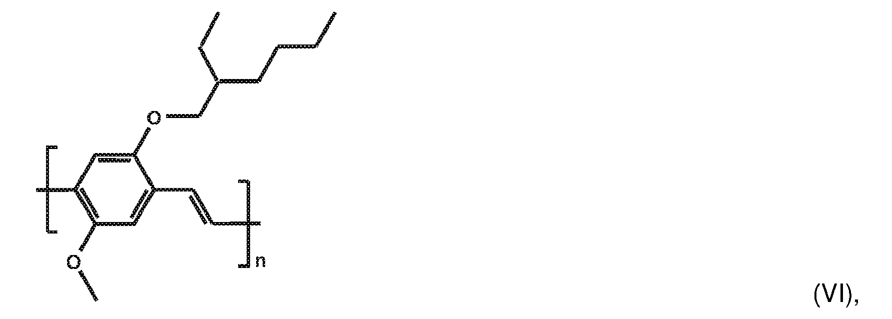 wherein R is a C₈-C₁₂ linear or branched alkyl chain, wherein x, y and z are such that Mw is from 10000 to 80000, wherein n is such that Mw is from 10000 to 80000.

7. The photovoltaic structure according to any of the preceding claims wherein the guest is selected from the group consisting of lanthanide metal chelates, heavy metal porphyrins, heavy metal phthalocyanines, iridium metal chelates and diketone derivatives having the following general formula: 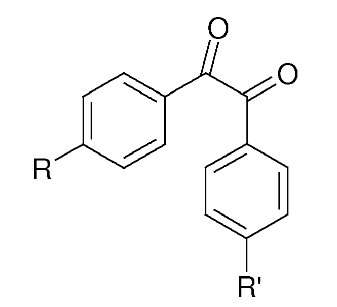 wherein R and R' are independently selected from the group consisting of H, CH₃, ethyl, propyl, -O-R" and NR"₂ and wherein R" is selected from the group consisting of H, CH₃, ethyl and propyl.

8. The photovoltaic structure according to claim 7, wherein the guest is selected from the group consisting of Tris[2-(2-pyridinyl)phenyl-C,N]-iridium (Ir(ppy)₃), Iridium (III) bis[4,6-di-fluorophenyl-pyridinato-*N*,*C*2] picolinate (Firpic), platinum octaethylporphyrin (PtOEP) and benzil.

9. The photovoltaic structure according to any of the previous claims wherein the weight ratio guest/host is from 0.001 to 0.20 or from 0.01 to 0.10 or from 0.02 to 0.09 or from 0.03 to 0.07.

10. The photovoltaic structure according to any of the previous claims wherein the electron acceptor layer and the electron donor layer form essentially a planar heterojunction.

11. The photovoltaic structure according to any of claims 1 to 9 comprising a layer wherein said semiconductor electron acceptor material and said semiconductor electron donor material are mixed to form a bulk heterojunction.

12. A photovoltaic structure according to any of claims 1 to 11, further comprising a first conductive layer on a first side of the photovoltaic structure and a second conductive layer on a second side of said photovoltaic structure, said first and second conductive layers being chosen so that at least one of said layers is at least partially transparent,

13. A method for manufacturing a photovoltaic cell comprising the steps of:
- providing a substrate having a conductive layer,
- applying on said conductive layer a photovoltaic structure according to claim 1.

14. A method according to claim 13, comprising the steps of:
- providing a substrate having a first conductive layer,
- optionally applying contacts on said first conductive layer,
- optionally applying a first set of one or more intermediate layers on said first conductive layer,
- applying a photovoltaic structure according to any of claims 1 to 11 on said first conductive layer or on top of said first set of one or more intermediate layers,
- optionally applying a second set of one or more intermediate layers on said photovoltaic structure, and
- optionally applying a second conductive layer on said photovoltaic structure or on top of said second set of intermediate layers.
wherein said first and second conductive layers are chosen so that at least one is at least partially transparent.

15. Use of photovoltaic structure according to any of claims 1 to 12 in the fabrication of a photovoltaic cell.

16. A method of operation of a photovoltaic cell comprising the steps of:
- providing a photovoltaic structure according to claim 12,
- connecting a load to said first and second conductive layer, and
- applying light to said photovoltaic structure, wherein said light comprises a wavelength that is at least partially absorbed by said host comprised in said electron donor material.
